# EUROPÄISCHE PATENTSCHRIFT

(11) **EP 0 545 058 B1**
(45) Veröffentlichungstag und Bekanntmachung des Hinweises auf die Patenterteilung: **31.01.1996**
(21) Anmeldenummer: 92118147.5
(22) Anmeldetag: 23.10.1992
(51) Int. Cl.: G01C 17/30, G01C 17/28, G01R 33/02

(54) **Richtungsänderungssensor für Kraftfahrzeuge**
Direction change sensor for motor vehicles
Capteur de changement de cap pour véhicules

(30) Priorität: 06.11.1991 DE 4136451
(43) Veröffentlichungstag der Anmeldung: 09.06.1993
(73) Patentinhaber: Mannesmann Kienzle GmbH, D-78052 Villingen-Schwenningen (DE)
(72) Erfinder: Fichter, Manfred, Ing. grad., W-7744 Königsfeld (DE); Hilger, Gernot, Dipl.-Phys., W-7218 Trossingen (DE)

(56) Entgegenhaltungen:
- WO-A-89/00297
- FR-A- 2 352 307
- US-A- 4 109 199

## Beschreibung

Die Erfindung betrifft einen Richtungsänderungssensor für ein in Kraftfahrzeugen verwendbares Unfalldatenregistriergerät mit wenigstens zwei rechtwinklig zueinander angeordneten und jeweils einen Kern aus amorphem, ferromagnetischem Metall aufweisenden Spulen, deren geometrische Achsen nach dem Einbau des Unfalldatenregistriergerätes in ein Kraftfahrzeug im wesentlichen horizontal ausgerichtet und deren Induktivitäten durch das Erdmagnetfeld steuerbar sind.

Mit dem Aufsatz "Magnetfeldmessung mit Sättigungskernsonden in der Fahrzeugtechnik" in Sensoren 1986/87 S. 105-110 sind Sensoren, die den jeweiligen Horizontalvektor des Erdmagnetfeldes ermitteln und dabei nach dem sog. Sättigungskernverfahren arbeiten, beschrieben worden. Derartige Sensoren sind, was auch aus der WO-A-89/00297 hervorgeht, für elektronische Kompasse einsetzbar, die ihrerseits in Verbindung mit Navigationsrechnern mit elektronisch gespeicherten Landkarten Anwendung finden. Eine solche Anwendung steht verständlicherweise, vom militärischen Einsatz abgesehen, nur für Fahrzeuge der oberen Preisklasse zur Diskussion, so daß für diese Anwendung nicht die für die Kraftfahrzeug-Instrumentierung üblicherweise geltenden Fertigungs- und Kostenmaßstäbe angelegt werden müssen. Die FR-A-2 352 307 befaßt sich mit einem stabförmigen Magnetometer für metallurgische Zwecke, d. h. ein Sensor dieser Art ist für das Erfassen von Richtungsänderungen nicht verwendbar.

Bei einer Anwendung beispielsweise in einem Gerät zur Datenerfassung für die Unfallrekonstruktion, mit anderen Worten in einem Unfalldatenregistriergerät, in welchem unter anderem fortgeschrieben werden sollen, dominieren die Bedingungen der Großserienfertigung, eine von den Kosten abhängige Akzeptanzschwelle und die Eignung für den Einbau des Gerätes bei einer Vielzahl von Kraftfahrzeugen unterschiedlichster Architektur. Letzere Forderung führt zu einer möglichst kleinen Bauform und somit einer weitgehenden Nutzung des festgelegten Geräteraumes, d. h. einer hohen Dichte der elektronischen Bauelemente. Dies hat die Gefahr von Wärmestaus zur Folge, die insbesondere bei Kraftfahrzeugen, wo durch Aufheizungen von außen eine rasche Wärmeableitung nicht immer gegeben ist, unter allen Umständen, d. h. durch eine konsequente Begrenzung der Stromaufnahme des Gerätes, vermieden werden muß. Selbstverständlich ist eine Begrenzung der Stromaufnahme auch deshalb unumgänglich, weil bei Ausfall der Stromversorgung des Kraftfahrzeuges, was im Falle eines Unfalles naheliegt, die Funktion des Gerätes mittels einer geeigneten Pufferung für eine definierte Zeit aufrechterhalten werden muß.

Die Aufgabe der vorliegenden Erfindung besteht somit darin, einen in einem Unfalldatenregistriergerät anwendbaren Richtungsänderungssensor im Hinblick auf eine großseriengerechte Fertigung optimal zu gestalten.

Die Lösung der Aufgabe sieht vor, daß im wesentlichen gleichgestaltete, jeweils eine Spule umfassende Oszillatoren vorgesehen sind und daß zur Festlegung der Arbeitsbereiche der Oszillatoren die amorph-metallischen Kerne der Spulen dauermagnetisch vorgespannt sind.

Eine bevorzugte Lösungsvariante ist dadurch gekennzeichnet, daß als Oszillatoren emittergekoppelte Oszillatoren Anwendung finden.

Eine weitere, vorteilhafte Ausbildung ist darin zu sehen, daß zwei Spulen derart angeordnet sind, daß die Spulenkerne mit jeweils einem Ende nahe beieinander liegen und daß diagonal zwischen den anderen Enden der Spulenkerne ein stabförmiger Dauermagnet vorgesehen ist.

Mit der gefundenen Lösung wird insbesondere erreicht, daß für die Festlegung der Arbeitsbereiche der Oszillatoren zwischen deren Grundfrequenz und der Frequenz im magnetisch gesättigten Zustand der Spulenkerne, mit anderen Worten für die magnetische Vorspannung der Spulenkerne derart, daß die durch das Erdmagnetfeld hervorgerufenen Frequenzänderungen im linearen Bereich der jeweiligen f/B-Kennlinien der Oszillatoren abgreifbar sind, keine zusätzliche elektrische Energie erforderlich ist. Die Verwendung von Dauermagneten hat außerdem den Vorteil, daß die Wirkungen des positiven Temperaturganges des amorph-metallischen Kernmaterials durch den entgegengesetzt verlaufenden Temperaturgang des Dauermagnetmaterials wenigstens bereichsweise kompensierbar sind.

Eine weitere vorteilhafte Maßnahme ist in der Wahl von emittergekoppelten Oszillatoren zu sehen, welche im Vergleich mit beispielsweise Colpittsoszillatoren einen geringeren Stromverbrauch aufweisen und mit weniger Bauteilen realisierbar sind.

Ferner kann der Richtungsänderungssensor derart gestaltet werden, daß für zwei, gegebenenfalls auch für drei Spulen nur ein Dauermagnet vorgesehen wird, der zum Ausgleich von Feldverzerrungen aufgrund in der Nähe befindlichen, ferromagnetischen Materials sowie von Fertigungs- und Anordnungstoleranzen der Spulen verschiebbar und auch drehbar gehaltert sein kann. Dabei ist aus montagetechnischen Gründen, aber auch weil dadurch eine gezieltere Magnetkreisabstimmung im Hinblick auf das umgebende Milieu möglich ist, eine unmittelbare Befestigung der Spulen und des Dauermagneten auf einer die elektronischen Bauelemente des Unfalldatenregistriergerätes tragenden Leiterplatte von Vorteil. Diese bei zwei Spulen sozusagen dreieckförmige Anordnung von Spulen und Dauermagnet eignet sich andererseits aber auch für die Schaffung einer selbständigen, mit der Leiterplatte steckbar kontaktierbaren Baueinheit. Es ist aber auch, wenn auf der an sich dicht bestückten Leiterplatte eine andere Flächennutzung vorgesehen werden muß, denkbar, die Spulen auf der Leiterplatte bei rechtwinklig zueinander stehenden Spulenachsen beliebig zu verteilen und jeder Spule einen Dauermagneten zuzuordnen.

In allen Fällen muß jedoch dafür gesorgt werden, daß, um eine optimale, d. h. reproduzierbare Empfindlichkeit mit stabilen Parametern und einen linearen Arbeitsbereich für einen praxisorientierten Signalhub zu erzielen, in den Spulenkernen eine homogene, magnetische Durchflutung vorherrscht. Diese Forderung ist insbesondere mit der dreieckförmigen Anordnung der beiden Spulen und des einen Dauermagneten sowie mit einem einer einzigen Spule zugeordneten U-förmig geformten Dauermagneten bei jeweils relativ langen Spulenkernen erzielbar.

Da der einem Unfalldatenregistriergerät zugrunde zu legende Kostenmaßstab und das gegebene Raumangebot eine kardanische Aufhängung des Richtungsänderungssensors nicht zulassen, andererseits bei der gewählten starren Anordnung des Richtungsänderungssensors Gefällstrecken und Steigungen sowie Nickbewegungen des Fahrzeugs relativ große Meßwertschwankungen der Horizontalkomponente des Erdmagnetfeldes verursachen, ist es zweckmäßig, den Richtungsänderungssensor zusätzlich mit einem Geber für die Vertikalkomponente des Erdmagnetfeldes auszustatten, d. h. es wird eine Anordnung aus drei jeweils rechtwinklig zueinander stehenden Spulen vorgesehen, denen ein in besonderer Weise, vorzugsweise spritzgießtechnisch gestalteter Dauermagnet zugeordnet ist sein kann.

Im folgenden Seien Ausführungsbeispiele der Erfindung anhand der beigefügten Zeichnungen näher erläutert. Es zeigen
Fig. 1 eine Oszillatorschaltung,
Fig. 2 ein f/B-Diagramm eines im erfindungsemäßen Richtungsänderungssensor verwendeten Oszillators,
Fig. 3 eine spezielle Ausbildung eines Richtungsänderungssensors und deren Anordnung auf einer die elektronischen Bauelemente eines Unfalldatenregistriergerätes tragenden Leiterplatte,
Fig. 4 eine Ausführungsform, bei der jeder Spule ein Dauermagnet zugeordnet ist,
Fig. 5 eine Ausführungsform mit einer am Spulenkörper ausgebildeten Halterung für einen Dauermagneten.

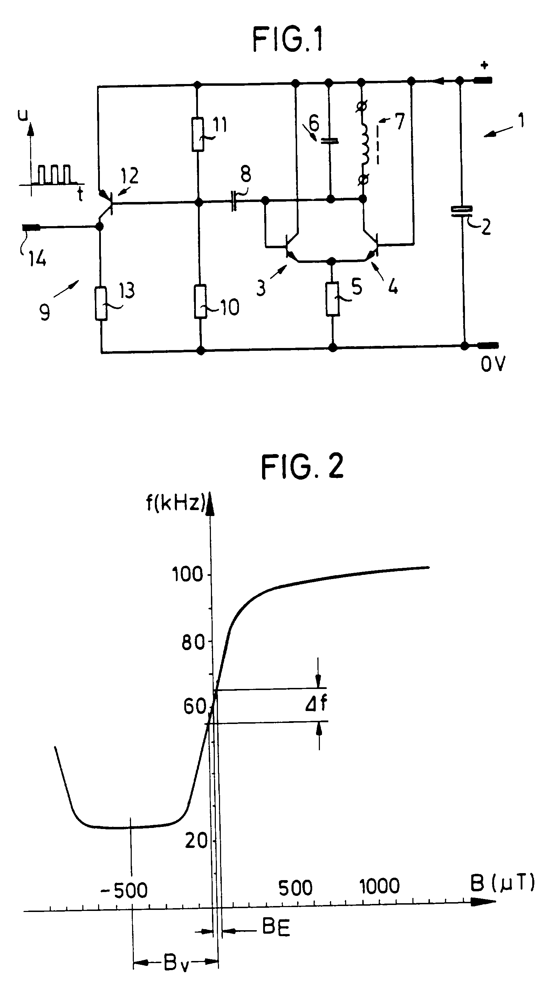

Die Schaltungsanordnung gemäß Fig. 1 stellt einen emittergekoppelten Oszillator 1 dar mit einer einem Siebkondensator 2, der dem Kurzschließen von Störspannungen dient, parallel geschalteten Schwingschaltung, bestehend aus einem zwei parallel geschalteten Transistoren 3 und 4 gemeinsam zugeordneten Emitterwiderstand 5 sowie einer Kapazität 6 eines Kondensators und einer parallel geschalteten Induktivität 7 einer Spule, welche die frequenzbestimmenden Größen der Schwingschaltung darstellen. Ein Kondensator 8 dient der Auskopplung des Signals der Schwingschaltung. Die dem Oszillator 1 nachgeschaltete Ausgangsstufe 9 besteht aus einem von Widerständen 10 und 11 gebildeten Spannungsteiler, welcher der Einstellung des Arbeitspunktes eines Transistors 12 dient. Mit 13 ist der Arbeitswiderstand des Transistors 12 bezeichnet. Nach dem Anlegen der Eingangsspannung steht an dem Ausgang 14 der Ausgangsstufe 9 ein Signal gemäß dem dargestellten Spannungs-Zeit-Diagramm an.

Wie das f/B-Diagramm Fig. 2 zeigt, beträgt der Frequenzhub des gewählten Ausführungsbeispiels zwischen der Grund- und der Sättigungsfrequenz 75 kHz, während der bei einer Drehung des Kraftfahrzeuges im Erdmagnetfeld um 180° für die Signalverarbeitung an sich ausreichende Signalhub Δf, bei der für die Spulendaten sich ergebenden Empfindlichkeit (Steilheit des linearen Bereichs) 10 kHz beträgt. Mit Bv ist die magnetische Vorspannung und mit B_{E} die Induktion des Erdmagnetfeldes bezeichnet.

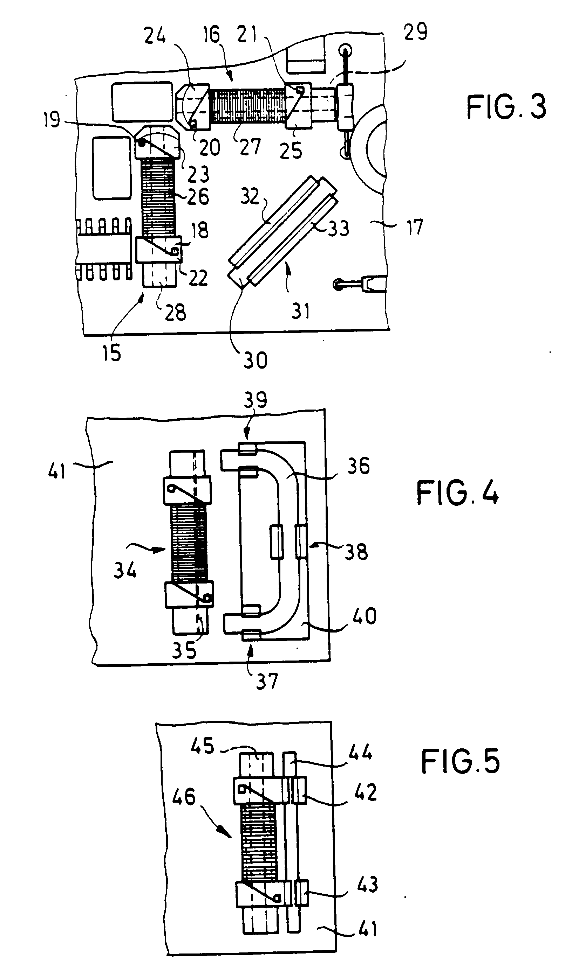

Die spezielle Ausbildung eines Richtungsänderungssensors gemäß Fig. 3 zeigt, daß zwei gleichgestaltete Spulen 15 und 16 auf einer Leiterplatte 17 des betreffenden Unfalldatenregistriergeräts rechtwinklig zueinander angeordnet sind, d. h. mittels Kontaktstiften 18, 19 bzw. 20, 21 und nicht dargestellter Fixierzapfen auf der Leiterplatte 17 befestigt und mit ebenfalls nicht gezeichneten Leiterbahnen kontaktiert sind. Der Vollständigkeit halber sei erwähnt, daß die Spulenkörper mit Wangen 22, 23 bzw. 24, 25 versehen sind, zwischen denen die jeweilige Wicklung 26, 27 auf einen zylindrischen Abschnitt aufgebracht ist. Die Wangen 22, 23 bzw. 24, 25 bilden die Standfläche der Spulen 15 und 16 auf der Leiterplatte 17. Zwei von ihnen - 23 und 24 - sind derart. gestaltet, daß die Spulen 15 und 16 relativ nahe beieinanderliegend angeordnet werden können. Ferner sei erwähnt, daß an jedem Spulenkörper eine über die gesamte Länge sich erstreckende Nut ausgebildet ist, in welche jeweils ein bandförmiger Spulenkern 28 bzw. 29 eingeklebt ist.

Außer den, weil nicht erfindungswesentlich nicht bezeichneten elektronischen Bauelementen im Bereich des Richtungsänderungssensors ist in der Fig. 3 ein stabförmiger Dauermagnet 30 dargestellt. Dies ist mittels eines beispielsweise U-förmigen Halters 31 auf der Leiterplatte 17 befestigt, wobei an dem Halter 31 geeignete Fixierzapfen und Rastklinken sowie federungsfähige Schenkel 32 und 33 ausgebildet sind.

Bei der Ausführungsform gemäß Fig. 4 ist die Spule 34 derart gestaltet, daß der bandförmige Spulenkern 35 gegenüber dem Ausführungsbeispiel gemäß Fig. 3 um 90° gedreht angeordnet ist. Der Spule 34 ist bei dieser Ausführungsform ein U-förmig gestalteter Dauermagnet 36 zugeordnet, welcher beispielsweise mittels geeigneter Schnappverbindungen 37, 38, 39 auf einem Träger 40 befestigt ist. Mit einer derartigen Magnetform läßt sich eine inhomogene Durchflutung des Spulenkerns minimieren. Der Träger 40 ist seinerseits in geeigneter Weise mit einer Leiterplatte 41 verbunden. Bei dieser Lösung lassen sich die beiden Geber des Richtungsänderungssensors unter Berücksichtigung, daß die geometrischen Achsen der Spulen rechtwinklig zueinander stehen, auf der Leiterplatte 41 beliebig verteilen und somit der Richtungsänderungssensor an die Bestückungssituation auf der Leiterplatte 41 anpassen.

Die Fig. 5 zeigt eine Lösung, bei der Schnappverbindungen 42, 43 für die Befestigung eines stabförmigen Dauermagneten 44 unmittelbar, vorzugsweise in einer relativ engen Parallellage zum Spulenkern 45, an einer Spule 46 bzw. an deren Spulenkörper ausgebildet sind. Bei dieser Lösung ist der Flächenbedarf auf der Leiterplatte 41 am geringsten.

## Patentansprüche

1. Richtungsänderungssensor für ein in Kraftfahrzeugen verwendbares Unfalldatenregistriergerät mit wenigstens zwei rechtwinklig zueinander angeordneten und jeweils einen Kern aus amorphem, ferromagnetischem Metall aufweisenden Spulen, deren geometrische Achsen nach dem Einbau des Unfalldatenregistriergerätes in ein Kraftfahrzeug im wesentlichen horizontal ausgerichtet und deren Induktivitäten durch das Erdmagnetfeld steuerbar sind,
dadurch gekennzeichnet,
daß im wesentlichen gleichgestaltete, jeweils eine Spule (15, 16, 34) umfassende Oszillatoren vorgesehen sind und
daß zur Festlegung der Arbeitsbereiche der Oszillatoren die amorph-metallischen Kerne (28, 29, 35) der Spulen (15, 16, 34) dauermagnetisch vorgespannt sind.

2. Richtungsänderungssensor nach Anspruch 1,
dadurch gekennzeichnet,
daß als Oszillatoren emittergekoppelte Oszillatoren (z. B. 1) Anwendung finden.

3. Richtungsänderungssensor nach Anspruch 1,
dadurch gekennzeichnet,
daß die Spulen (15, 16, 34) und die den Spulen zugeordneten Dauermagnete in beliebigem Abstand zueinander auf einer die elektronischen Bauelemente des Unfalldatenregistriergerätes tragenden Leiterplatte (17, 41) angeordnet sind.

4. Richtungsänderungssensor nach Anspruch 3,
dadurch gekennzeichnet,
daß an den Spulenkörpern jeweils eine Halterung (42, 43) für einen Dauermagneten (44) ausgebildet ist.

5. Richtungsänderungssensor nach Anspruch 3,
dadurch gekennzeichnet,
daß die Spulen (15, 16, 34) in unterschiedlichen, parallelen Ebenen angeordnet sind.

6. Richtungsänderungssensor nach Anspruch 3,
dadurch gekennzeichnet,
daß den Spulen (15, 16, 34) jeweils ein nicht stabförmiger Dauermagnet (36) zugeordnet ist.

7. Richtungsänderungssensor nach Anspruch 1,
dadurch gekennzeichnet,
daß zwei Spulen (15, 16) derart angeordnet sind, daß die Spulenkerne (28, 29) mit jeweils einem Ende nahe beieinander liegen und
daß diagonal zwischen den anderen Enden der Spulenkerne (28, 29) ein stabförmiger Dauermagnet (30) vorgesehen ist.

8. Richtungsänderungssensor nach Anspruch 7,
dadurch gekennzeichnet,
daß die Oszillatoren (1) auf einer nur diese tragenden Leiterplatte angeordnet sind und diese Baueinheit mit der Leiterplatte (17) des Unfalldatenregistriergerätes steckbar kontaktierbar ist.

9. Richtungsänderungssensor nach Anspruch 1,
dadurch gekennzeichnet,
daß drei Spulen jeweils rechtwinklig derart zueinander angeordnet sind, daß sich ihre geometrischen Achsen in einem Punkt schneiden und
daß ein Dauermagnet den Spulen derart räumlich zugeordnet ist, daß ein Pol des Dauermagneten in Richtung des Schnittpunktes der Spulenachsen weist.

## Claims

1. Direction change sensor for an accident data recorder usable in motor vehicles, having at least two coils arranged at right angles to one another and each possessing a core made of amorphous, ferromagnetic metal, the geometric axes of the said coils being oriented substantially horizontally after installation of the accident data recorder in a motor vehicle and their inductances being controllable by the earth's magnetic field, characterised in that oscillators of substantially the same design and each comprising a coil (15, 16, 34) are provided and in that the amorphous-metallic cores (28, 29, 35) of the coils (15, 16, 34) are biased by means of a permanent magnet in order to define the operating ranges of the oscillators.

2. Direction change sensor according to Claim 1, characterised in that emitter-coupled oscillators (e.g. 1) are used as the oscillators.

3. Direction change sensor according to Claim 1, characterised in that the coils (15, 16, 34) and the permanent magnets assigned to the coils are arranged at any desired distance from one another on a printed circuit board (17, 41) carrying the electronic components of the accident data recorder.

4. Direction change sensor according to Claim 3, characterised in that there is constructed on the coil formers in each case a mounting (42, 43) for a permanent magnet (44).

5. Direction change sensor according to Claim 3, characterised in that the coils (15, 16, 34) are arranged in different, parallel planes.

6. Direction change sensor according to Claim 3, characterised in that a permanent magnet (36) which is not bar-shaped is assigned in each case to the coils (15, 16, 34).

7. Direction change sensor according to Claim 1, characterised in that two coils (15, 16) are arranged such that the coil cores (28, 29) lie close together with in each case one of their ends and in that a bar-shaped permanent magnet (30) is provided diagonally between the other ends of the coil cores (28, 29).

8. Direction change sensor according to Claim 7, characterised in that the oscillators (1) are arranged on a printed circuit board carrying only these and this unit can be pluggably contacted with the printed circuit board (17) of the accident data recorder.

9. Direction change sensor according to Claim 1, characterised in that three coils are arranged in each case at right angles to one another such that their geometric axes intersect at a point and in that a permanent magnet is spatially assigned to the coils such that one pole of the permanent magnet points in the direction of the point of intersection of the coil axes.

## Revendications

1. Détecteur de changement de direction pour un enregistreur de données d'accident utilisable dans des véhicules automobiles avec au moins deux bobines disposées perpendiculairement l'une par rapport à l'autre et présentant chacune un noyau en un métal ferromagnétique amorphe, dont les axes géométriques sont, après l'installation dudit enregistreur de données d'accident dans un véhicule automobile, disposés, pour l'essentiel, horizontalement et dont les inductivités peuvent être commandées par le champ magnétique terrestre,
caractérisé par le fait
qu'il est prévu des oscillateurs, pour l'essentiel uniformes, englobant respectivement une bobine (15, 16, 34) et que, pour la détermination des zones de fonctionnement des oscillateurs, les noyaux métalliques amorphes (28, 29, 35) des bobines (15, 16, 34) possèdent une polarisation magnétique permanente.

2. Détecteur de changement de direction selon la
revendication 1,
caractérisé par le fait que les oscillateurs utilisés sont des oscillateurs à couplage d'émetteur (par exemple 1).

3. Détecteur de changement de direction selon la revendication 1,
caractérisé par le fait
que les bobines (15, 16, 34) et les aimants permanents associés auxdites bobines sont disposés à des distances quelconques les uns par rapport aux autres sur une platine à circuits imprimés (17, 41) portant les composants électroniques de l'enregistreur de données d'accident.

4. Détecteur de changement de direction selon la revendication 3,
caractérisé par le fait
que sur les mandrins de bobine est formé respectivement un support (42, 43) pour un aimant permanent (44).

5. Détecteur de changement de direction selon la revendication 3,
caractérisé par le fait
que les bobines (15, 16, 34) sont disposées dans des plans parallèles différents.

6. Détecteur de changement de direction selon la revendication 3,
caractérisé par le fait
qu'aux bobines (15, 16, 34) est associé respectivement un aimant permanent (36) ne présentant pas la forme d'un bâtonnet.

7. Détecteur de changement de direction selon la revendication 1,
caractérisé par le fait
que deux bobines (15, 16) sont disposées de telle sorte que les noyaux de bobine (28, 29) sont rapprochés les uns des autres par respectivement une extrémité et
que, diagonalement entre les autres extrémités des noyaux de bobine, il est prévu un aimant permanent (30) en forme de bâtonnet.

8. Détecteur de changement de direction selon la revendication 7,
caractérisé par le fait
que les oscillateurs (1) sont disposés sur une platine à circuits imprimés ne portant que ces derniers et que ce sous-ensemble peut être mis en contact par enfichage avec la platine à circuits imprimés (17) de l'enregistreur de données d'accident.

9. Détecteur de changement de direction selon la revendication 1,
caractérisé par le fait
que trois bobines sont respectivement disposées perpendiculairement l'une par rapport à l'autre, de telle sorte que leurs axes géométriques se coupent dans un point et
qu'un aimant permanent est spatialement associé auxdites bobines, de telle sorte qu'un pôle dudit aimant permanent soit dirigé vers le point d'intersection des axes de bobine.
